# FASCICULE DE BREVET EUROPEEN

(11) **EP 1 396 016 B1**
(45) Date de publication et mention de la délivrance du brevet: **16.02.2011**
(21) Numéro de dépôt: 02745525.2
(22) Date de dépôt: 13.06.2002
(51) Int. Cl.: H01L 21/3065, H01L 21/764, H01L 21/762, H01L 21/316

(54) **TRANCHEE D'ISOLEMENT ET SON PROCEDE DE REALISATION**
ISOLIERGRABEN UND VERFAHREN ZU DESSEN HERSTELLUNG
INSULATING TRENCH AND METHOD FOR PRODUCTION THEREOF

(30) Priorité: 14.06.2001 FR 0107774
(43) Date de publication de la demande: 10.03.2004
(73) Titulaire: STMicroelectronics S.A., 92120 Montrouge (FR)
(72) Inventeur: MARTY, Michel, F-38760 Saint Paul de Varces (FR); FORTUIN, Arnoud, F-38920 Crolles (FR); ARNAL, Vincent, F-38000 Grenoble (FR)
(74) Mandataire: Poulin, Gérard
(86) Numéro de dépôt international: PCT/FR2002/002029
(87) Numéro de publication internationale: WO 2002/103772

(56) Documents cités:
- EP-A- 0 908 936
- EP-A- 0 908 936
- WO-A-01/04955
- US-A- 4 533 430
- US-A- 4 845 048
- US-A- 5 943 581
- PATENT ABSTRACTS OF JAPAN vol. 014, no. 117 (E-0898), 5 mars 1990 (1990-03-05) -& JP 01 315161 A (FUJITSU LTD), 20 décembre 1989 (1989-12-20)
- PATENT ABSTRACTS OF JAPAN vol. 2000, no. 09, 13 octobre 2000 (2000-10-13) -& JP 2000 183149 A (SANYO ELECTRIC CO LTD), 30 juin 2000 (2000-06-30)
- PATENT ABSTRACTS OF JAPAN vol. 009, no. 027 (E-294), 6 février 1985 (1985-02-06) & JP 59 172246 A (SEIKO DENSHI KOGYO KK), 28 septembre 1984 (1984-09-28)

## Description

### DOMAINE TECHNIQUE

La présente invention est relative à la fabrication de circuits intégrés et notamment de circuits dans des technologies bipolaires ou BiCMOS. Les tranchées d'isolement profondes creusées dans le substrat sont destinées à isoler les différents composants du circuit entre eux et à minimiser les composantes parasites qui existent entre les structures. Elles sont connues par la dénomination anglo-saxonne de DTI pour Deep Trench Isolation. Par profonde on veut dire que la profondeur des tranchées est supérieure à leur largeur et qu'elle est largement supérieure à la profondeur des couches enterrées qui se trouvent dans le substrat. Ces tranchées profondes permettent de séparer ces couches enterrées N+ et P+ et par là même de diminuer la composante périmétrique de la capacité collecteur/substrat. Ces capacités interviennent dans le calcul du bruit des circuits et sur la fréquence d'oscillation des transistors bipolaires.

### ETAT DE LA TECHNIQUE ANTERIEURE

Les tranchées d'isolement profondes entourent les transistors bipolaires et elles sont remplies de matériau électriquement isolant. Dans les circuits en silicium qui est de loin le matériau le plus utilisé dans l'industrie microélectronique, le matériau utilisé est généralement de l'oxyde de silicium.

Il existe aujourd'hui diverses méthodes de réalisation de ces tranchées d'isolement profondes. Elles peuvent être réalisées en fin de procédé après la réalisation des transistors ou bien en début de procédé avant la réalisation des transistors.

Lorsque les tranchées sont faites en fin de procédé, leur périmètre est grand, du fait qu'ils ne faut évidemment pas couper les éléments du transistor. La composante surfacique de la capacité collecteur/substrat est inchangée avec ou sans tranchée profonde. Le gain sur la composante périmétrique réside dans le fait que la valeur de la capacité par unité de longueur de la tranchée est inférieure à la capacité de jonction existant en l'absence de tranchée. Avec de telles tranchées, le gain total sur la capacité collecteur/substrat est limité.

En réalisant les tranchées en début de procédé, on peut limiter leur périmètre car il est possible alors d'empiler, par exemple, la prise de contact de la base au dessus de la tranchée. On réduit la capacité périmétrique collecteur/substrat par rapport à la configuration précédente. Mais une fois que les tranchées sont remplies de matériau électriquement isolant, le substrat va être soumis à un certain nombre de cycles thermique pour la réalisation des transistors ou d'autres composants et ces cycles vont générer des contraintes mécaniques importantes entre le substrat et le matériau de remplissage, ces contraintes étant générées par la différence des coefficients de dilatation thermiques entre le silicium et le matériau de remplissage des tranchées. Entre le silicium et le dioxyde de silicium couramment utilisé pour remplir les tranchées, la différence dans les coefficients de dilatation thermique est de l'ordre de la décade.

Au delà d'un seuil de contraintes, on peut générer des dislocations dans le matériau du substrat. Lorsque les dislocations coupent les jonctions, les courants de fuite des jonctions sont très importants et le circuit est inutilisable. Cet inconvénient est très limité dans le cas où les tranchées sont réalisées en fin de procédé car le circuit ne subit plus alors après le remplissage des tranchées de cycles à des températures élevées.

Pour limiter l'apparition de ces dislocations, il a été proposé d'utiliser, dans le cas où les tranchées sont réalisées en début de procédé, un remplissage composite avec deux matériaux différents, par exemple on peut recouvrir ses flancs et son fond d'une couche d'oxyde et remplir tout l'intérieur de silicium polycristallin. Mais la valeur de la capacité linéaire d'un remplissage composite est supérieure à la valeur d'un remplissage avec de l'oxyde, la permittivité relative du silicium polycristallin étant trois à quatre fois plus importante que celle du dioxyde de silicium.

Le document JP01315161 décrit une tranchée d'isolement dont les caractéristiques sont celles de la partie caractérisante de la revendication 1.

Le document JP2000183149 décrit une tranchée d'isolement dont la partie supérieure des flancs comporte des espaceurs délimitant un col, elle a un profil évasé depuis le col en s'éloignant du fond.

Le document WO 01/04955 décrit des tranchées d'isolement dont les flancs en vis-à-vis sont sensiblement parallèles.

Le document EP 0 908 936 décrit un procédé de formation d'une tranchée d'isolement en forme de bouteille avec des flancs évasés mais sans bouchon.

### EXPOSÉ DE L'INVENTION

La présente invention propose au contraire une tranchée d'isolement dont la capacité d'isolement est minimisée et qui n'apporte pas de risque de dislocation du substrat.

Pour y parvenir la tranchée d'isolement selon l'invention comporte les caractéristiques anoncées dans la revendication 1.5a tranchée d'isolement profonde comporte des flancs et un fond dans un substrat semi-conducteur, ces flancs et ce fond sont tapissés d'un matériau électriquement isolant. Ce même matériau électriquement isolant délimite une cavité vide et forme un bouchon pour fermer la cavité. Les flancs de la tranchée sont configurés avec un col qui détermine la position-en profondeur du bouchon et une première portion qui s'évase depuis le col en s'éloignant du fond.

En aménageant dans la cavité un vide, c'est à dire un espace sans matériau solide mais avec de l'air et/ou des gaz résiduels, on réduit la capacité: parasite de la tranchée car la permittivité relative de l'air et/ou des gaz résiduels est de l'ordre de 1 alors que celle du matériau électriquement isolant, généralement de l'oxyde de silicium, est supérieure à 4.

Du fait de la présence de la cavité vide et du volume réduit du matériau électriquement isolant qui ne fait que tapisser les flancs et le fond de la tranchée profonde, les risques de dislocation dans le substrat sont réduits. La couche de matériau électriquement isolant qui délimite la cavité vide possède une relative élasticité, caractéristique que ne possède pas un bloc massif.

La première portion aura une profondeur dans le substrat semi-conducteur comprise entre environ 0,2 et 1 micromètre.

La première portion évasée peut avoir une pente comprise entre environ 50 et 85 degrés.

La plus grande largeur de la première portion pourra être égale à environ deux fois la largeur du col.

Entre le col et le fond, les flancs peuvent comporter une seconde portion dans laquelle ils sont sensiblement parallèles.

Mais si l'on veut maximiser le volume de la cavité vide, il est préférable que les flancs comportent une seconde portion entre le col et le fond, cette seconde portion s'évasant depuis le col en se rapprochant du fond. Les flancs ont alors le profil d'une bouteille.

Dans un autre mode de réalisation, les flancs peuvent comporter une seconde portion qui est bombée entre le col et le fond. Les flancs ont alors le profil d'une bonbonne.

Quant au fond il peut être bombé ou être sensiblement plat.

La tranchée d'isolement profonde est destinée à coopérer avec une tranchée d'isolement peu profonde creusée dans le substrat semi-conducteur et pleine de matériau électriquement isolant. Elle comporte un fond et des flancs. La partie la plus large de la première portion débouche alors dans le fond de la tranchée d'isolement peu profonde.

L'invention concerne également un circuit intégré qui comporte au moins une tranchée d'isolement ainsi définie et un appareil électronique ou électrique qui comporte au moins un tel circuit intégré.

La présente invention concerne aussi un procédé de réalisation d'une tranchée d'isolement selon les caractéristiques de la revendication 12. Elle comporte une tranchée d'isolement profonde dans un substrat semi-conducteur, cette tranchée possédant un fond, des flancs et une ouverture. Le procédé comporte les étapes suivantes pour réaliser la tranchée d'isolement profonde:
dépôt sur le substrat d'une couche de matériau électriquement isolant pour réaliser un masque dur;
gravure dans le masque dur d'une ouverture correspondant à celle de la tranchée ;
gravure à travers le masque dur, dans les matériau semi-conducteur, des flancs et du fond de la tranchée en prévoyant un col entre le fond et l'ouverture et en réalisant une première portion des flancs qui est rétrécie depuis l'ouverture vers le col puis une seconde portion des flancs comprise entre le col et le fond;
élimination du masque dur;
dépôt non conforme d'un matériau électriquement isolant qui tapisse les flancs et le fond, qui délimite une cavité vide et qui forme un bouchon pour fermer la cavité.

La gravure de la tranchée peut se faire par plasma avec un mélange gazeux ayant de premières proportions pour réaliser la première portion des flancs et de secondes proportions pour réaliser la seconde portion des flancs.

Le mélange gazeux peut contenir de l'acide bromhydrique HBr, de l'oxygène O₂ et de l'hexafluorure de soufre SF₆.

Le mélange gazeux contiendra une plus grande proportion d'hexafluorure de soufre SF₆ pour réaliser la seconde portion des flancs qu'il n'en contient pour réaliser la première portion des flancs.

Le procédé peut comporter, après l'étape de gravure, une étape de recuit thermique visant à restaurer l'état de surface des flancs et du fond.

Le procédé peut comporter après l'étape de gravure, une étape d'implantation ionique au niveau de la tranchée, cette implantation ionique étant d'un type opposé au type du substrat semi-conducteur.

Le matériau électriquement isolant déposé pour tapisser les flancs et le fond peut être dopé, l'étape de dépôt étant suivie d'une étape de recuit thermique rapide provoquant un fluage du matériau électriquement isolant.

Le procédé selon l'invention peut comporter une étape de retrait, en surface, du matériau électriquement isolant déposé pour tapisser le fond et les flancs et si nécessaire une étape de planarisation en surface.

La tranchée d'isolement profonde coopère avec une tranchée d'isolement peu profonde avec des flancs et un fond, l'ouverture de la tranchée d'isolement profonde débouchant dans le fond de la tranchée d'isolement peu profonde. Le procédé comporte une étape de gravure de la tranchée d'isolement peu profonde avant l'étape de dépôt du matériau électriquement isolant réalisant le masque dur.

L'étape de dépôt non conforme du matériau électriquement isolant contribue à remplir la tranchée d'isolement peu profonde.

### BRÈVE DESCRIPTION DES DESSINS

D'autres caractéristiques et avantages de l'invention apparaîtront à la lecture de la description qui suit illustrée par les figures jointes.
Les figures 1A, 1B, 1C représentent, en coupe transversale, plusieurs exemples de tranchées d'isolement profondes.
Les figures 2A à 2H illustrent le déroulement des étapes d'un procédé de réalisation d'une tranchée d'isolement profonde.
La figure 3 représente une coupe transversale d'une tranchée d'isolement profonde selon l'invention qui coopère avec une tranchée d'isolement peu profonde.
Les figures 4A à 4E illustrent le déroulement des étapes d'un procédé de réalisation d'une tranchée d'isolement profonde conforme à l'invention, cette tranchée d'isolement profonde coopérant avec une tranchée d'isolement peu profonde réalisée en même temps.
La figure 5 montre schématiquement un appareillage électronique ou électrique.

### EXPOSÉ DÉTAILLÉ DE MODES DE RÉALISATION PARTICULIERS

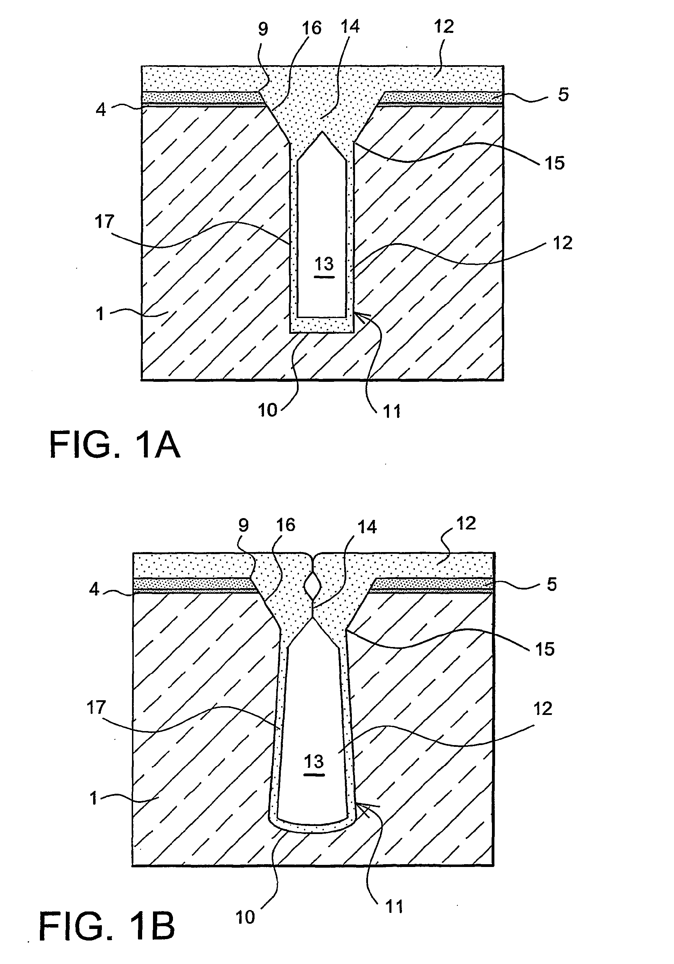

Des exemples de tranchées profondes sont illustrés aux figures 1A à 1C. On a représenté schématiquement un circuit intégré avec un substrat 1 en matériau semi-conducteur d'un type dans lequel une tranchée d'isolement profonde a été creusée.

La tranchée d'isolement profonde comporte un fond 10, des flancs 11 et une ouverture 9. Selon l'invention, le fond 10 et les flancs 11 creusés dans le matériau semi-conducteur, sont recouverts d'un matériau électriquement isolant 12 qui délimite une cavité vide 13 fermée en profondeur par un bouchon 14, les flancs 11 comportant un col 15 qui définit la position du bouchon 14 et une première portion 16 qui s'évase depuis le col 15 vers l'ouverture 9 en s'éloignant du fond 10. La pente de cette première portion 16 est dite positive.

La plus grande largeur de la première portion 16 pourra être égale à environ deux fois la largeur du col 15.

Par cavité vide 13, on entend une cavité qui est vide de matériau solide. Dans la partie vide se trouve de l'air et/ou des gaz résiduels qui se forment lors du remplissage de la tranchée avec le matériau électriquement isolant 12.

Entre le col 15 et le fond 10, sur une seconde portion 17 les flancs peuvent être sensiblement parallèles comme sur la figure 1A.

Mais généralement on cherche, pour une largeur de tranchée donnée, à augmenter le volume de la cavité vide 13 pour réduire la capacité d'isolement en minimisant l'épaisseur du matériau électriquement isolant 12 qui délimite la cavité vide 13. En effet, la permittivité relative de l'air ou des gaz résiduels se trouvant dans la cavité 13 est bien inférieure à celle du matériau électriquement isolant 12. Dans ce cas, il est préférable que les flancs 11 comportent une seconde portion 18 évasée depuis le col 15 vers le fond 10. Le profil des flancs 11 ressemble à celui d'une bouteille. Le fond 10 peut être arrondi. Cette variante est illustrée à la figure 1B.

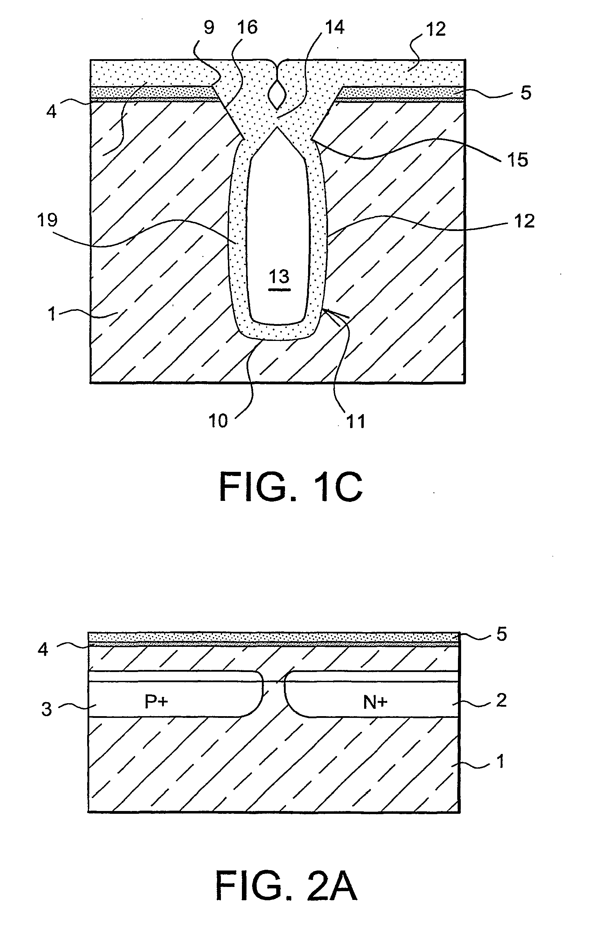

I1 est possible d'augmenter encore le volume de la cavité vide 13 en configurant les flancs 11 de manière à ce qu'ils comportent une seconde portion 19 évasée et bombée entre le col 15 et le fond 10. Le profil des flancs avec une telle concavité s'apparente à celui d'une bonbonne. Cette variante est illustrée à la figure 1C. Le fond 10 est représenté arrondi, mais il aurait pu être sensiblement plat. Un fond arrondi est préférable pour éviter les contraintes dues aux accidents de forme risquant de survenir avec un fond plat.

Les pentes des secondes portions 18 ou 19 sont dites négatives et l'intérêt de flancs à pente négative est de minimiser l'épaisseur du matériau électriquement isolant 12.

On va maintenant décrire un procédé de réalisation d'une tranchée d'isolement profonde dans un substrat semi-conducteur 1. On se réfère aux figures 2A à 2H.

Cette tranchée va être réalisée en début de procédé de fabrication avant que des transistors n'aient été réalisés. Toutefois, la tranchée d'isolement profonde devant isoler un transistor (non représenté) du substrat, on a déjà réservé dans le substrat semi-conducteur 1, que l'on suppose en silicium, des zones actives dopées enterrées 2, 3 de types opposés N+ et P+ respectivement. On suppose également que le substrat 1 a été épitaxié en surface après réservation des zones enterrées. Le substrat semi-conducteur 1 est de préférence-recouvert d'isolant qui servira ultérieurement notamment lors de la réalisation des transistors, on trouve d'abord une mince couche d'oxyde 4, dans l'exemple de l'oxyde de silicium, qui recouvre le substrat semi-conducteur 1 puis une couche de nitrure sacrificiel 5, dans l'exemple du nitrure de silicium, qui recouvre l'oxyde. La couche de nitrure peut avoir une épaisseur comprise, par exemple, entre 5 et 20 nanomètres (figure 2A).

On commence par un dépôt de matériau électriquement isolant 6 qui va servir de masque dur pour la gravure de la tranchée d'isolement profonde. Dans l'exemple, le matériau électriquement isolant est par exemple de l'oxyde de silicium déposé par réactions chimiques en phase vapeur et plus précisément par décomposition de tétraéthylorthosilicate connu sous l'abréviation TEOS. L'épaisseur d'oxyde est comprise par exemple entre 200 et 400 nanomètres. A cause de la profondeur à graver une résine photosensible seule ne conviendrait pas.

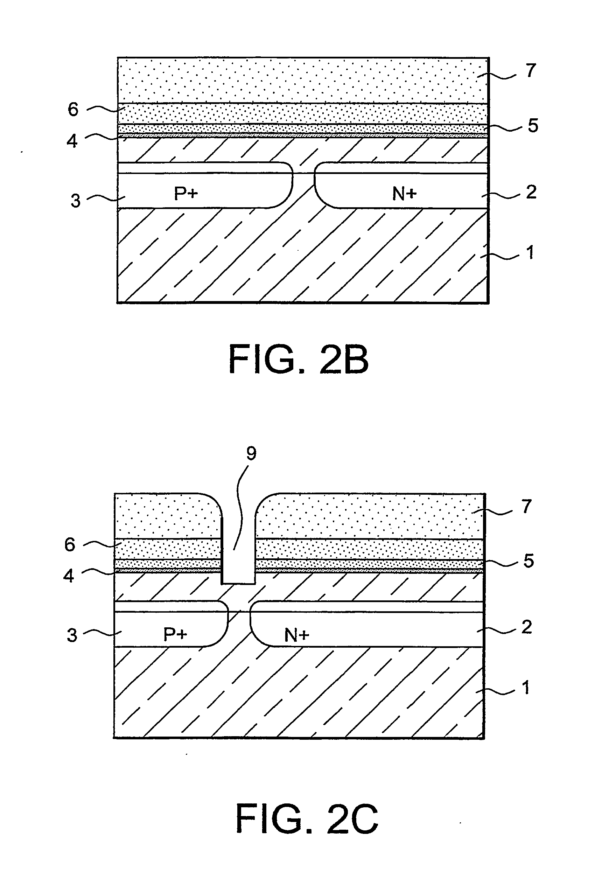

L'étape suivante est un dépôt de résine photosensible 7 sur la couche d'oxyde 6 précédente (figure 2B).

On va ensuite déterminer le motif de la tranchée profonde en transférant le motif approprié, qui correspond à l'ouverture 9 de la tranchée, sur la résine 7 et en la développant.

Une première étape de gravure intervient pour former une ouverture dans le masque dur 6, cette ouverture correspondant à celle 9 de la tranchée. En ouvrant le masque dur 6, on en profite pour mettre à nu le silicium du substrat 1 et donc pour graver le nitrure 5 et l'oxyde fin 4. Cette-gravure peut être une gravure par plasma en utilisant un gaz qui attaque le nitrure et l'oxyde et qui est sélectif vis à vis du silicium (figure 2C).

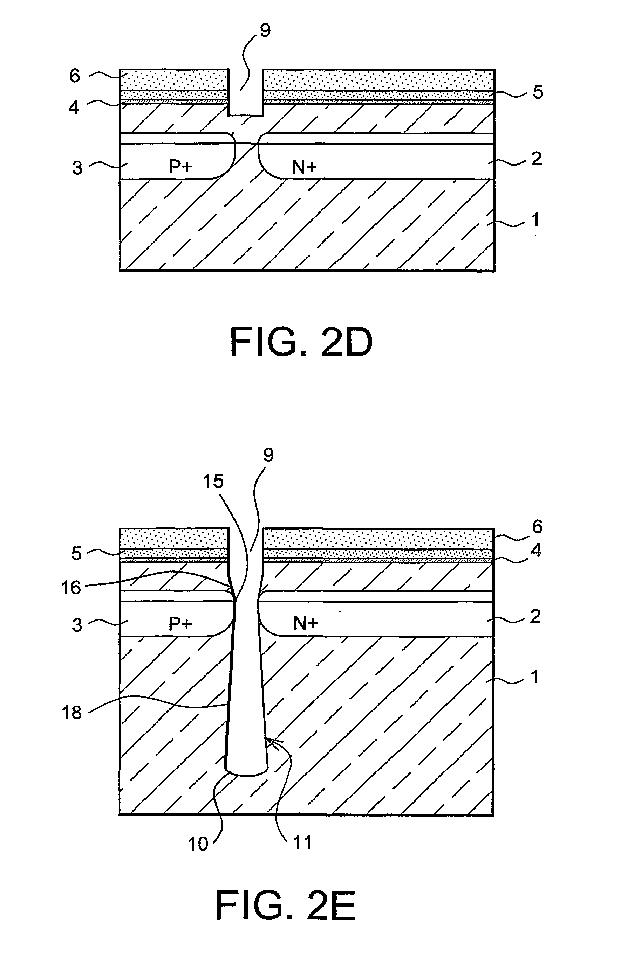

L'étape suivante est une étape de retrait de la résine 7 (figure 2D) .

Il va falloir ensuite graver les flancs 11 et le fond 10 de la tranchée profonde. La gravure est une gravure sèche assistée par plasma par exemple de type réactive RIE. Cette gravure va se faire en deux temps pour pouvoir obtenir le profil requis avec le col 15 et les deux portions 16 et 17 ou 18, ou 19 de part et d'autre du col 15. On commence par graver la première portion 16 qui est évasée depuis le col 15 en s'éloignant du fond 10 ou à l'inverse qui se rétrécit depuis l'ouverture 9 en allant vers le col 15 puisque c'est dans cette direction que s'effectue la gravure.

La profondeur de cette première portion 16 est comprise par exemple entre 0,2 et 1 micromètre à partir de la surface du substrat semi-conducteur. L'inclinaison des flancs de la première portion 16 évasée peut être comprise entre environ 50 et 85 degrés par rapport à la surface du substrat 1 qui est recouverte du masque 6. La pente a une grande importance pour être sûr de bien obtenir la cavité vide lorsqu'on remplira la tranchée. Dans l'art antérieur, on cherchait au contraire à remplir totalement la tranchée d'isolement en évitant de former des vides et les flancs étaient parallèles sur toute la profondeur de la tranchée.

La gravure de la première portion 16 évasée se fait avec un mélange gazeux à base d'acide bromhydrique HBr et d'oxygène O₂ et d'hexafluorure de soufre SF₆. Ce mélange gazeux attaque le matériau du substrat de manière anisotrope, cela permet de réaliser la pente souhaitée. A cause de la présence de l'oxygène, il se forme de l'oxyde de silicium qui se dépose sur les flancs 11 et au fond 10. Or l'acide bromhydrique HBr ne grave pas l'oxyde ainsi créé, seul l'hexafluorure de soufre SF₆ peut graver cet oxyde. Les proportions des trois gaz sont ajustées pour obtenir le profil souhaité pour la première portion 16 évasée. La gravure de l'oxyde déposé au fond se fait de manière beaucoup plus rapide que celle de l'oxyde déposé sur les flancs.

Lorsqu'on arrive au col 15, on change les proportions des gaz du mélange pour pouvoir graver la seconde portion 17, 18 ou 19 de flancs comprise entre le fond 10 et le col 15 et qui possède une pente diffférente de celle de la première portion 16. Le mélange gazeux contient une plus grande quantité d'hexafluorure de soufre SF₆ pour pouvoir continuer la gravure en profondeur avec la pente souhaitée. La seconde portion des flancs aura, de préférence, une profondeur supérieure à environ 3 micromètres. Cette étape est illustrée à la figure 2E.

L'ajustement des proportions des gaz dans le mélange gazeux, de la pression dans l'enceinte utilisée et de la puissance haute fréquence pour créer le plasma permet de déterminer le taux d'anisotropie et la vitesse de gravure et ces deux facteurs définissent la pente et la profondeur des différentes portions. On contrôle alors parfaitement pente et profondeur pendant la gravure.

On peut faire, de manière classique, au niveau de la tranchée profonde qui vient d'être gravée, une implantation ionique, de type opposé à celui du substrat 1, de façon à dévier des lignes de courant qui prennent naissance dans le substrat 1 en vue d'éviter des fuites de courant.

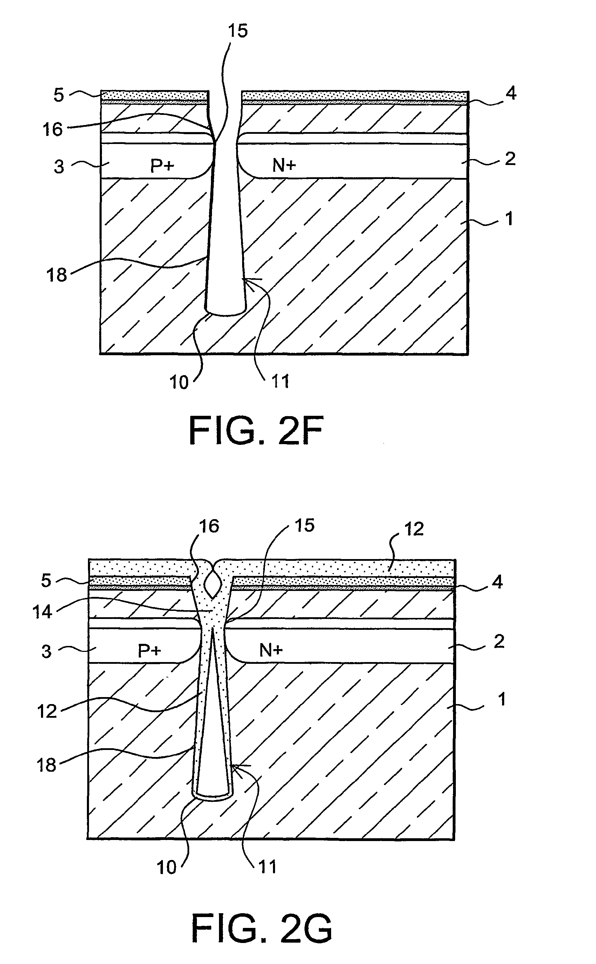

On élimine ensuite le masque dur 6 et les résidus de gravure, ces résidus comprennent l'oxyde qui s'est formé pendant la gravure de la tranchée (figure 2F). L'oxyde qui s'est formé dans la tranchée profonde lors de sa gravure n'est pas représenté car il est très fin. Cette élimination peut se faire chimiquement dans un bain d'acide fluorhydrique HF dilué par exemple.

On peut ensuite soumettre la tranchées profonde à un recuit par exemple de type RTO (Rapid Thermal Oxidation pour oxydation thermique rapide) de manière à restaurer l'état de surface de ses flancs et de son fond endommagés par la gravure et donc de limiter la circulation de courants de fuite qui pourrait prendre naissance au niveau de ces surfaces endommagées.

L'étape suivante est une étape de remplissage de la tranchée de matériau électriquement isolant en créant la cavité vide 13 et le bouchon de fermeture 14 (figure 2G). Ce dépôt de matériau électriquement isolant 12 qui dans l'exemple est de l'oxyde de silicium peut se faire par réactions chimiques en phase vapeur CVD, réactions chimiques en phase vapeur assistées par plasma PECVD avec au moins un précurseur rendant le dépôt non conforme ou par plasma haute densité.

Un dépôt non conforme se fait le plus rapidement sur les surfaces horizontales que sur les surfaces verticales. Ce dépôt se fait donc plus rapidement sur la première portion 16 évasée et sur la surface du substrat 1 que sur la seconde portion 17, 18, 19 et sur le fond 10. Le bouchon 14 se forme dans la partie la plus étroite de la première portion évasée 16 au voisinage du col 15. Il ferme donc en profondeur la cavité vide 13 située entre le fond 10 et le col 15.

Comme précurseur on peut utiliser du TEOS ou du silane SiH₄.

Le matériau électriquement isolant 12 peut être dopé par exemple l'oxyde de silicium peut être dopé au bore ou au phosphore. Une étape de recuit thermique intervient ensuite pour faire fluer le matériau électriquement isolant ce qui permet d'ajuster la position du bouchon de fermeture 14.

Une telle tranchée d'isolement profonde est particulièrement robuste, les couches enterrées 2, 4 qui viennent en butée contre ses flancs 11 sont bloquées lors de traitements thermiques ultérieurs. Il n'est plus nécessaire de réaliser une implantation P+ en fond de tranchée profonde comme dans l'art antérieur où la tranchée traversait une zone enterrée.

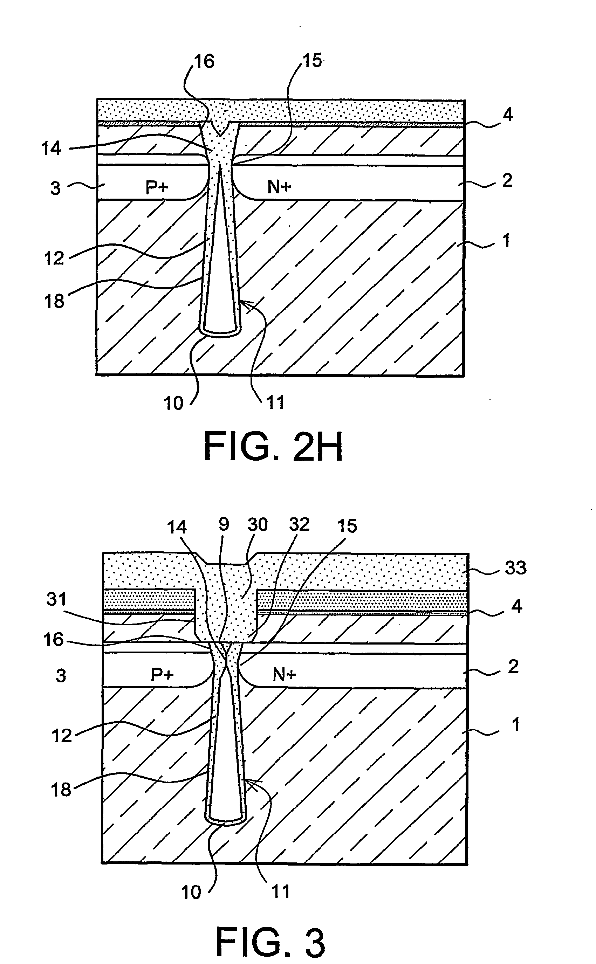

Pour terminer, on peut par exemple par un polissage mécano-chimique ôter l'oxyde 12 ainsi déposé et se trouvant en surface et si nécessaire réaliser une étape de planarisation en surface (figure 2H).

Dans les circuits bipolaires et BiCMOS, les tranchées d'isolement profondes coopèrent avec des tranchées d'isolement peu profondes connues sous la dénomination anglosaxonne de STI pour Shallow Trench Isolation. Par tranchée d'isolement peu profonde, on entend une tranchée dont la profondeur est inférieure à celle des caissons dans lesquels sont placés les transistors.

La tranchée d'isolement peu profonde 30 comporte des flancs 31, un fond 32 et est pleine de matériau électriquement isolant 33. Son fond 32 débouche dans la première portion 16 évasée de la tranchée d'isolement profonde référencée 20. Cette coopération est représentée à la figure 3. Le fond 32 de la tranchée peu profonde 30 est plus large que l'ouverture 9 de la tranchée d'isolement profonde, c'est à dire plus large que la plus grande largeur de la première portion 16 évasée.

Selon un exemple non revendiqué, la réalisation de la tranchée d'isolement peu profonde peut se faire après celle de la tranchée d'isolement profonde.

Mais on peut également débuter la réalisation de la tranchée d'isolement peu profonde avant de débuter celle de la tranchée d'isolement profonde et dans ce cas des étapes sont communes pour la réalisation des deux tranchées d'isolement.

On va voir maintenant un procédé de réalisation de tranchées d'isolement profondes qui inclut la réalisation de tranchées d'isolement peu profondes.

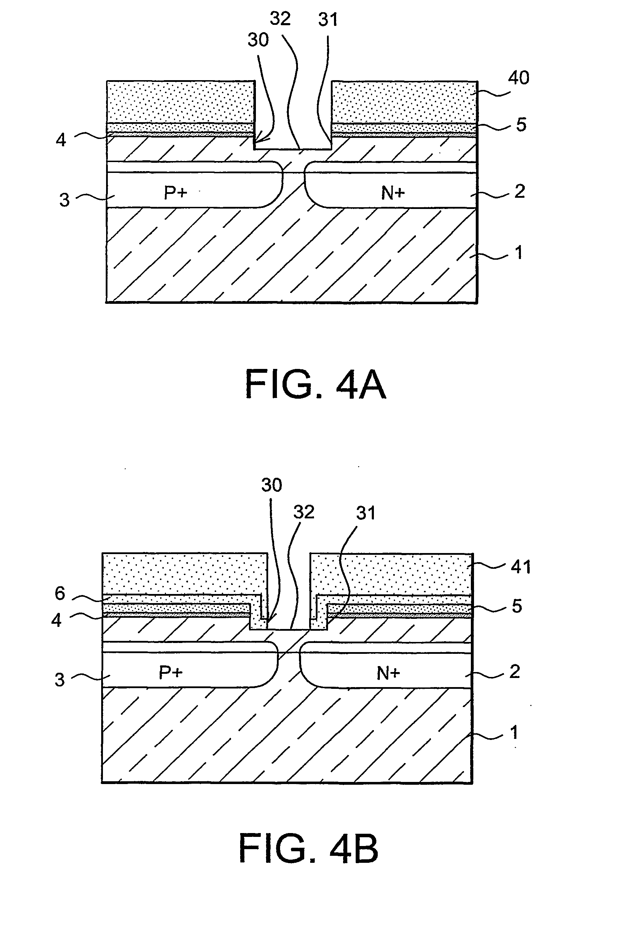

On part d'un substrat 1 de même nature que celui représenté à la figure 2A avec sa couche d'oxyde 4 et sa couche de nitrure sacrificiel 5. On commence par graver la tranchée d'isolement peu profonde 30. On effectue une étape de lithographie avec un dépôt de résine 40 sur la couche de nitrure 5, le transfert du motif approprié qui correspond à l'ouverture 9 de la tranchée sur la résine, le développement de la résine 40. La gravure de la tranchée peu profonde se fait ensuite par plasma. On réalise cette fois ci une gravure anisotrope (figure 4A).

L'étape suivante est une étape de retrait de la résine 40.

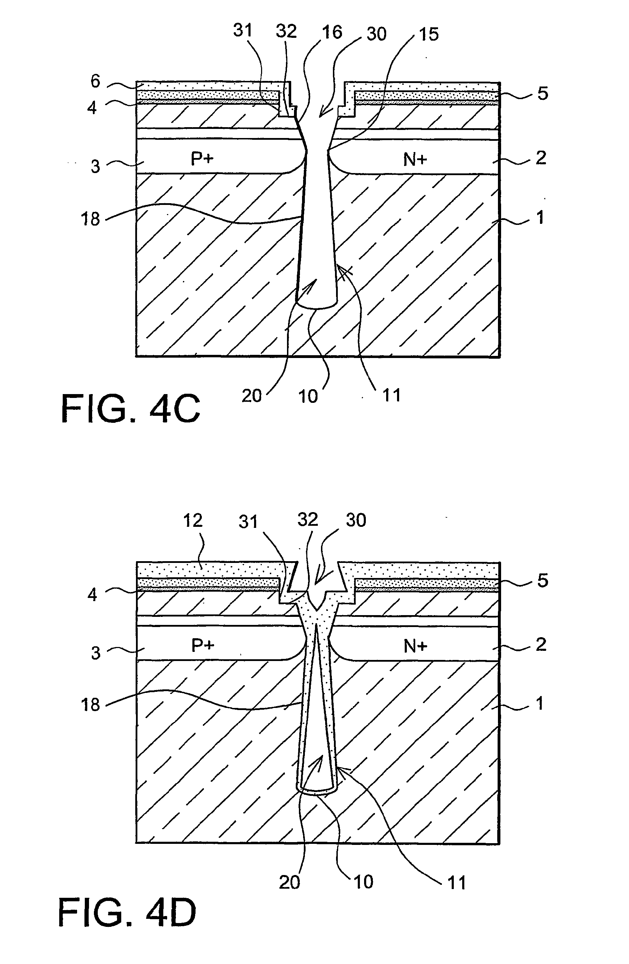

Ensuite on dépose le matériau électriquement isolant 6 qui va servir de masque dur pour la gravure de la tranchée d'isolement profonde 30. Il va recouvrir les flancs 31 et le fond 32 de la tranchée d'isolement peu profonde 30. Cette étape a été décrite à la figure 2B. On va ensuite réaliser les étapes décrites aux figures 2B et suivantes à savoir l'étape de lithographie avec de la résine référencée 41, conduisant à la gravure du masque dur 6 (figure 4B), le retrait de la résine 41. On peut alors débuter la gravure de la tranchée d'isolement profonde comme décrit précédemment. Cette étape est illustrée à la figure 4C, elle se fait depuis le fond 32 de la tranchée d'isolement peu profonde 30.

On peut ensuite faire l'implantation ionique dans la tranchée d'isolement profonde.

L'étape suivante est une étape d'élimination du masque dur 6 ainsi que de l'oxyde qui s'est formé dans la tranchée profonde.

Pour restaurer l'état de surface des flancs et fonds des deux tranchées d'isolement, il est possible de les soumettre au recuit de type RTO.

L'étape suivante est l'étape de remplissage des tranchées en aménageant le vide dans la tranchée d'isolement, profonde 20 et en remplissant totalement la tranchée d'isolement 30 peu profonde.

Cette étape se fait comme précédemment avec le dépôt non conforme du matériau électriquement isolant 12 qui conduit à la formation du bouchon 14 dans le substrat 1 mais également au remplissage de la tranchée d'isolement peu profonde (figure 4D).

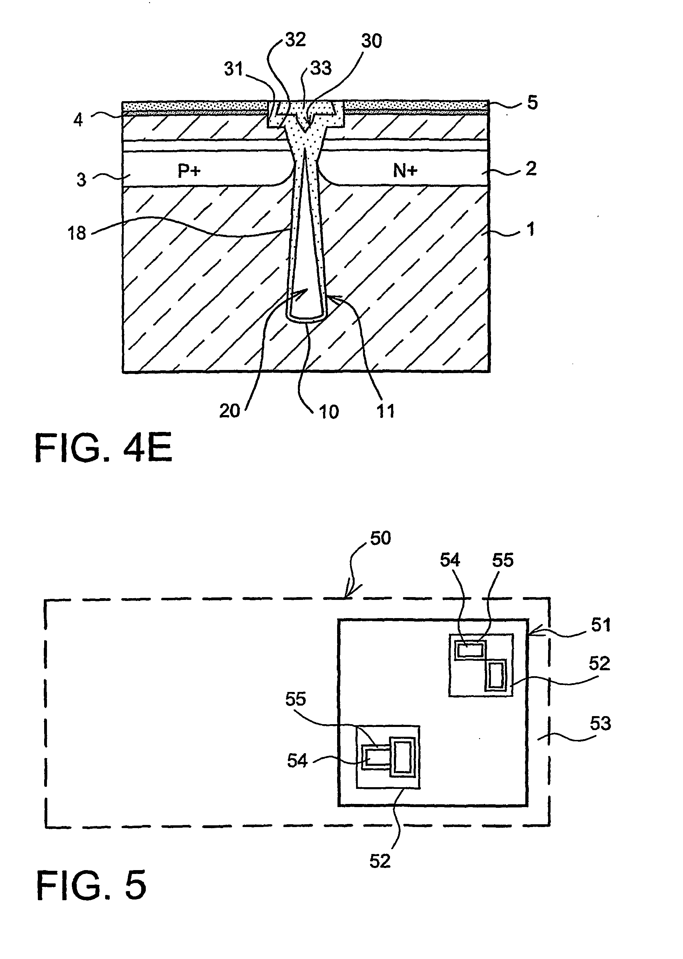

A l'issu de cette étape, la tranchée d'isolement peu profonde 30 peut ne pas être remplie totalement. On termine donc de la remplir en réalisant par CVD par exemple un dépôt 33 de matériau électriquement isolant conforme. Dans l'exemple on peut terminer par un polissage mécanochimique avec arrêt dans le nitrure 5 de manière à obtenir une surface plane (figure 4E).

La présente invention n'est pas limitée ni aux matériaux, ni aux techniques de dépôt et de gravure cités dans les exemples décrits.

La présente invention concerne également, comme représenté schématiquement sur la figure 5, un appareillage électronique ou électrique 50 muni d'un dispositif semi-conducteur 51 incluant au moins un circuit intégré 52 sur un substrat 53, ce circuit intégré 52 ayant des composants ou des ensembles de composants 54 entourés par au moins une tranchée d'isolement profonde 55 ainsi décrite. Comme appareillage électronique ou électrique, on peut citer par exemple un téléphone, mobile ou un amplificateur de ligne utilisé dans des bases pour communications de téléphonie sans fil.

## Revendications

1. Tranchée d'isolement comportant une tranchée d'isolement profonde avec des flancs (11) et un fond (10) dans un substrat semi-conducteur, les flancs (11) et le fond (10) étant tapissés d'un matériau électriquement isolant (12) qui délimite une cavité vide (13) et qui forme un bouchon (14) de fermeture de la cavité (13), les flancs (11) de la tranchée d'isolement profonde étant configurés avec un col (15) qui détermine la position en profondeur du bouchon (14) et une première portion (16) qui s'évase depuis le col (15) en s'éloignant du fond (10), **caractérisée en ce qu'**elle comporte en outre une tranchée d'isolement peu profonde (30), creusée dans le substrat semi-conducteur (1), destinée à coopérer avec la tranchée d'isolement profonde, comportant un fond (32) et des flancs (31), pleine de matériau électriquement isolant (12, 33), la partie la plus large de la première portion (16) de la tranchée d'isolement profonde débouchant dans le fond (32) de la tranchée d'isolement peu profonde (30).

2. Tranchée d'isolement selon la revendication 1, **caractérisée en ce que** la première portion (16) de la tranchée d'isolement profonde a une profondeur dans le substrat semi-conducteur (1) comprise entre environ 0,2 et 1 micromètre.

3. Tranchée d'isolement selon l'une des revendications 1 ou 2, **caractérisée en ce que** la première portion (16) de la tranchée d'isolement profonde a une pente qui fait un angle compris entre environ 50 et 85 degrés.

4. Tranchée d'isolement selon l'une des revendications 1 à 3, **caractérisée en ce que** la plus grande largeur de la première portion (16) de la tranchée d'isolement profonde est égale à environ deux fois la largeur du col (15).

5. Tranchée d'isolement selon l'une des revendications 1 à 4, **caractérisée en ce que** les flancs (11) de la tranchée d'isolement profonde comportent une seconde portion (17) entre le col (15) et le fond (10) dans laquelle ils sont sensiblement parallèles.

6. Tranchée d'isolement selon l'une des revendications, 1 à 4, **caractérisée en ce que** les flancs (11) de la tranchée d'isolement profonde comportent une seconde portion (18) entre le col (15) fond (10), cette seconde portion (18) s'évasant depuis le col (15) en se rapprochant du fond (10).

7. Tranchée d'isolement selon l'une des revendications 1 à 4, **caractérisée en ce que** les flancs (11) de la tranchée d'isolement profonde comportent une seconde portion (18) entre le col (15) et le fond (10), cette seconde portion (18) étant évasée et bombée.

8. Tranchée d'isolement selon l'une des revendications 1 à 7, **caractérisée en ce que** le fond (10) de la tranchée d'isolement profonde est sensiblement plat.

9. Tranchée d'isolement selon l'une des revendications 1 à 7, **caractérisée en ce que** le fond (10) de la tranchée d'isolement profonde est arrondi.

10. Circuit intégré, **caractérisé en ce qu'**il comporte au moins une tranchée d'isolement selon l'une quelconque des revendications 1 à 9.

11. Appareillage électronique ou électrique, **caractérisé en ce qu'**il comporte au moins un circuit intégré selon la revendication 10.

12. Procédé de réalisation d'une tranchée d'isolement dans un substrat semi-conducteur (1), cette tranchée comportant une tranchée profonde ayant un fond (10), des flancs (11) et une ouverture (9), cette tranchée d'isolement profonde coopérant avec une tranchée d'isolement peu profonde (30) avec des flancs (31) et un fond (32), l'ouverture (9) de la tranchée d'isolement profonde débouchant dans le fond (32) de la tranchée d'isolement peu profonde (30), comportant les étapes suivantes :
gravure dans le substrat semi-conducteur de la tranchée d'isolement peu profonde,
dépôt sur le substrat (1) d'une couche de matériau électriquement isolant pour réaliser un masque dur (6) de manière à ce qu'il recouvre les flancs (31) et le fond (32) de la tranchée d'isolement peu profonde (30) ;
gravure dans le masque dur (6) d'une ouverture correspondant à celle (9) de la tranchée d'isolement profonde ;
gravure à travers le masque dur (6) dans le matériau semi-conducteur des flancs (11) et du fond (10) de la tranchée d'isolement profonde en prévoyant un col (15) entre le fond (10) et l'ouverture (9) et en réalisant une première portion (16) des flancs (11) qui est rétrécie depuis l'ouverture (9) vers le col (15) puis une seconde portion (17, 18, 19) des flancs (11) comprise entre le col (15) et le fond (10) ;
élimination du masque dur (6) ;
dépôt non conforme d'un matériau électriquement isolant (12) qui tapisse les flancs (11) et le fond (10) de la tranchée d'isolement profonde, qui délimite une cavité vide (13) dans la tranchée d'isolement profonde, qui forme un bouchon (14) pour fermer la cavité (13) et qui remplit la tranchée d'isolement peu profonde (30).

13. Procédé de réalisation d'une tranchée d'isolement selon la revendication 12, **caractérisé en ce que** la gravure à travers le masque dur se fait par plasma avec un mélange gazeux ayant de premières proportions pour réaliser la première portion (16) des flancs (11) de la tranchée d'isolement profonde et de secondes proportions pour réaliser la seconde portion (17, 18, 19) des flancs (11) de la tranchée d'isolement profonde.

14. Procédé de réalisation d'une tranchée d'isolement selon la revendication 13, **caractérisé en ce que** le mélange gazeux contient de l'acide bromhydrique HBr, de l'oxygène O₂ et de l'hexafluorure de soufre SF₆.

15. Procédé de réalisation d'une tranchée d'isolement selon l'une des revendications 13 ou 14, **caractérisé en ce que** le mélange gazeux contient une plus grande proportion d'hexafluorure de soufre SF₆ pour réaliser la seconde portion (17, 18, 19) des flancs (11) de la tranchée d'isolement profonde qu'il n'en contient pour réaliser la première portion (16) des flancs (11) de la tranchée d'isolement profonde.

16. Procédé de réalisation d'une tranchée d'isolement selon l'une des revendications 12 à 15, **caractérisé en ce que** le matériau électriquement isolant (12) déposé pour tapisser les flancs (11) et le fond (10) de la tranchée d'isolement profonde est dopé, l'étape de dépôt étant suivie d'une étape de recuit thermique provoquant un fluage du matériau électriquement isolant (12).

17. Procédé de réalisation d'une tranchée d'isolement selon l'une des revendications 12 à 16, **caractérisé en ce qu'**il comporte une étape de retrait, en surface du matériau électriquement, isolant (12) déposé pour tapisser le fond (10) et les flancs (11) de la tranchée d'isolement profonde, suivie si nécessaire d'une étape de planarisation.

18. Procédé de réalisation d'une tranchée d'isolement selon l'une des revendications 12 à 17, **caractérisé en ce qu'**il comporte après l'étape de gravure à travers le masque dur une étape de recuit thermique visant à restaurer l'état de surface des flancs (11) et du fond (10) de la tranchée d'isolement profonde.

19. Procédé de réalisation d'une tranchée d'isolement selon l'une des revendications 12 à 18, **caractérisé en ce qu'**il comporte après l'étape de gravure à travers le masque dur, une étape d'implantation ionique au niveau de la tranchée d'isolement profonde, cette implantation ionique étant d'un type opposé au type du substrat semi-conducteur (1).

## Claims

1. Isolating trench comprising a deep isolating trench with sides (11) and a bottom (10) in a semiconducting substrate (1) the sides (11) and the bottom (10) being coated with and electrically insulating material (12) that delimits an empty cavity (13) and that forms a closing plug (14) of the cavity (13), the sides (11) of the deep isolating trench being configured with a neck (15) that determines the depth of the plug (14), and a first portion (16) that tapers outwards from the neck (15) as the distance from the bottom (10) increases, **characterized in that** it further comprises a shallow isolating trench (30), excavated in the semiconducting substrate (1), intended to cooperate with the deep isolating trench, comprising a bottom (32) and sides (31), full of electrically insulating material (12, 33), the widest part of the first portion (16) of the deep isolating trench opening up into the bottom (32) of the shallow isolating trench (30).

2. Isolating trench according to claim 1, **characterized in that** the first portion (16) of the deep isolating trench is at a depth in the semiconducting substrate (1) of between about 0.2 and 1 micrometer .

3. Isolating trench according to either of claims 1 and 2, **characterized in that** the angle of the slope of the first portion (16) of the deep isolating trench is between about 50 and 85 degrees.

4. Isolating trench according to any one of claims 1 to 3, **characterized in that** the maximum width of the first portion (16) of the deep isolating trench is equal to about twice the width of the neck (15).

5. Isolating trench according to any one of claims 1 to 4, **characterized in that** the sides (11) of the deep isolating trench comprise a second portion (17) between the neck (15) and the bottom (10), in which they are approximately parallel.

6. Isolating trench according to any one of claims 1 to 4, **characterized in that** the sides (11) of the deep isolating trench have a second portion (18) between the neck (15) and the bottom (10), this second portion (18) tapering outwards from the neck (15) as the distance from the bottom (10) reduces.

7. Isolating trench according to any one of claims 1 to 4, **characterized in that** the sides (11) of the deep isolating trench comprise a second portion (18) between the neck (15) and the bottom (10), this second portion (18) being tapered outwards and convex.

8. Isolating trench according to any one of claims 1 to 7, **characterized in that** the bottom (10) of the deep isolating trench is approximately flat.

9. Isolating trench according to any one of claims 1 to 7, **characterized in that** the bottom (10) of the deep isolating trench is rounded.

10. Integrated circuit **characterized in that** it comprises at least one isolating trench according to any one of claims 1 to 9.

11. Electronic or electrical apparatus **characterized in that** it comprises at least one integrated circuit according to claim 10.

12. Process for forming an isolating trench in a semiconducting substrate (1), this trench comprising a deep isolating trench with a bottom (10), sides (11) and an opening (9), said deep isolating trench cooperating with a shallow isolating trench (30) with sides (31) and a bottom (32), the opening (9) of the deep isolating trench opening up into the bottom (32) of the shallow isolating trench (30),
comprising the following steps :
. etching the shallow isolating trench in the semiconducting substrate,
. deposition on the substrate (1) of a layer of an electrically insulating material to make a hard mask (6) so that it covers the sides (31) and the bottom (32) of the shallow isolating trench (30) ;
. etching an opening corresponding to the opening (9) of the trench, in the hard mask (6);
. etching the sides (11) and the bottom (10) of the deep isolating trench through the hard mask (6) in the semiconducting material, providing a neck (15) between the bottom (10) and the opening (9) and making a first portion (16) of the sides (11) that gets smaller from the opening (9) towards the neck (15), then a second portion (17, 18, 19) of the sides (11) between the neck (15) and the bottom (10);
· elimination of the hard mask (6);
· nonconform deposition of an electrically insulating material (12) that coats the sides (11) and the bottom (10) of the deep isolating trench, that delimits an empty cavity (13) in the deep isolating trench, that forms a plug (14) to close the cavity (13) and that fills the shallow isolating trench (30).

13. Process for forming an isolating trench according to claim 12, **characterized in that** etching through the hard mask is done by plasma using a gaseous mix with first proportions to make the first portion (16) of the sides (11) of the deep isolating trench and second proportions to make the second portion (17, 18, 19) of the sides (11) of the deep isolating trench.

14. Process for forming an isolating trench according to claim 13, **characterized in that** the gaseous mix contains hydrobromic acid HBr, oxygen O₂ and sulfur hexafluoride SF₆.

15. Process for forming an isolating trench according to one of claims 13 or 14, **characterized in that** the gaseous mix contains a larger proportion of sulfur hexafluoride SF₆ to make the second portion (17, 18, 19) of the sides (11) of the deep isolating trench than to make the first portion (16) of the sides (11) of the deep isolating trench.

16. Process for making an isolating trench according to one of claims 12 to 14, **characterized in that** the electrically insulating material (12) deposited to coat the sides (11) and the bottom (10) of the deep isolating trench is doped, the deposition step being followed by a thermal annealing step causing the electrically insulating material (12) to creep.

17. Process for making an isolating trench according to one of claims 12 to 16, **characterized in that** it comprises a step for surface removal of the electrically insulating material (12) deposited to coat the bottom (10) and the sides (11) of the deep isolating trench, if necessary followed by a surface leveling step.

18. Process for making an isolating trench according to one of claims 12 to 17, **characterized in that** it comprises a thermal annealing step after the etching step through the hard mask, designed to restore the surface condition of the sides (11) and the bottom (10) of the deep isolating trench.

19. Process for forming an isolating trench according to any of claims 12 to 18, **characterized in that** it comprises an ionic implantation step on the deep isolating trench after the etching step through the hard mask, this ionic implantation being of the type opposite to the type of implantation of the semiconducting substrate (1).

## Patentansprüche

1. Isoliergraben, umfassend einen tiefen Isoliergraben mit Flanken (11) und einem Boden (10) in einem Halbleitersubstrat, wobei die Flanken (11) und der Boden (10) mit einem elektrisch isolierenden Material (12) bedeckt sind, das einen leeren Hohlraum (13) begrenzt und einen Stopfen (14) bildet, welcher den Hohlraum (13) schließt, wobei die Flanken (11) des tiefen Isoliergrabens mit einem Hals (15) ausgebildet sind, der die Tiefenposition des Stopfens (14) bestimmt, und mit einem ersten Abschnitt (16), der sich ausgehend vom Hals (15) vom Boden (10) weg aufweitet, **dadurch gekennzeichnet, dass** er ferner einen wenig tiefen Isoliergraben (30) umfasst, der in das Halbleitersubstrat (1) gegraben und dazu ausgelegt ist, mit dem tiefen Isoliergraben zusammenzuwirken und der einen Boden (32) und Flanken (31) umfasst, gefüllt mit elektrisch isolierendem Material (12, 33), wobei der breiteste Teil des ersten Bereichs (16) des tiefen Isoliergrabens in den Boden (32) des wenig tiefen Isoliergrabens (30) mündet.

2. Isoliergraben nach Anspruch 1, **dadurch gekennzeichnet, dass** der erste Bereich (16) des tiefen Isoliergrabens eine Tiefe in dem Halbleitersubstrat (1) hat, die zwischen ungefähr 0,2 und 1 Mikrometer enthalten ist.

3. Isoliergraben nach einem der Ansprüche 1 oder 2, **dadurch gekennzeichnet, dass** der erste Bereich (16) des tiefen Isoliergrabens eine Schräge aufweist, die einen Winkel bildet, welcher zwischen ungefähr 50 und 85 Grad enthalten ist.

4. Isoliergraben nach einem der Ansprüche 1 bis 3, **dadurch gekennzeichnet, dass** die größte Breite des ersten Bereichs (16) des tiefen Isoliergrabens ungefähr gleich zwei mal der Breite des Halses (15) ist.

5. Isoliergraben nach einem der Ansprüche 1 bis 4, **dadurch gekennzeichnet, dass** die Flanken (11) des tiefen Isoliergrabens einen zweiten Bereich (17) zwischen dem Hals (15) und dem Boden (10) umfassen, in welchem sie im Wesentlichen parallel sind.

6. Isoliergraben nach einem der Ansprüche 1 bis 4, **dadurch gekennzeichnet, dass** die Flanken (11) des tiefen Isoliergrabens einen zweiten Bereich (18) zwischen dem Hals (15) und dem Boden (10) umfassen, wobei sich dieser zweite Bereich (18) ausgehend vom Hals (15) in Annäherung an den Boden (10) aufweitet.

7. Isoliergraben nach einem der Ansprüche 1 bis 4, **dadurch gekennzeichnet, dass** die Flanken (11) des tiefen Isoliergrabens einen zweiten Bereich (18) zwischen dem Hals (15) und dem Boden (10) umfassen, wobei dieser zweite Bereich (18) aufgeweitet und gewölbt ist.

8. Isoliergraben nach einem der Ansprüche 1 bis 7, **dadurch gekennzeichnet, dass** der Boden (10) des tiefen Isoliergrabens im Wesentlichen flach ist.

9. Isoliergraben nach einem der Ansprüche 1 bis 7, **dadurch gekennzeichnet, dass** der Boden (10) des tiefen Isoliergrabens abgerundet ist.

10. Integrierte Schaltung, **dadurch gekennzeichnet, dass** sie wenigstens einen Isoliergraben nach einem der Ansprüche 1 bis 9 umfasst.

11. Elektronisches oder elektrisches Gerät, **dadurch gekennzeichnet, dass** es wenigstens eine integrierte Schaltung nach Anspruch 10 umfasst.

12. Verfahren zur Herstellung eines Isoliergrabens in einem Halbleitersubstrat (1), wobei dieser Graben einen tiefen Graben mit einem Boden (10), mit Flanken (11) und mit einer Öffnung (9) umfasst, wobei dieser tiefe Isoliergraben mit einem wenig tiefen Isoliergraben (30) mit Flanken (31) und mit einem Boden (32) zusammenwirkt, wobei die Öffnung (9) des tiefen Isoliergrabens in den Boden (32) des wenig tiefen Isoliergrabens (30) mündet, umfassend die folgenden Schritte:
Ätzen des wenig tiefen Isoliergrabens in das Halbleitersubstrat,
Aufbringen einer Schicht aus elektrisch isolierendem Material auf das Substrat (1), um eine harte Maske (6) zu realisieren, derart, dass sie die Flanken (31) und den Boden (32) des wenig tiefen Isoliergrabens (30) bedeckt;
Ätzen einer Öffnung in die harte Maske (6), die jener (9) des tiefen Isoliergrabens entspricht;
Ätzen, durch die harte Maske (6) hindurch, in das Halbleitermaterial der Flanken (11) und des Bodens (10) des tiefen Isoliergrabens unter Bereitstellung eines Halses (15) zwischen dem Boden (10) und der Öffnung (9) und unter Realisierung eines ersten Bereichs (16) der Flanken (11), der von der Öffnung (9) ausgehend zum Hals (15) hin verengt ist, und dann eines zweiten Bereichs (17, 18, 19) der Flanken (11), der zwischen dem Hals (15) und dem Boden (10) enthalten ist;
Beseitigen der harten Maske (6);
Nicht-konformes Abscheiden eines elektrisch isolierenden Materials (12), das die Flanken (11) und den Boden (10) des tiefen Isoliergrabens bedeckt, welches einen leeren Hohlraum (13) in dem tiefen Isoliergraben begrenzt und einen Stopfen (14) bildet, um den Hohlraum (13) zu schließen, und weiches den wenig tiefen Isoliergraben (30) füllt.

13. Verfahren zur Herstellung eines Isoliergrabens nach Anspruch 12, **dadurch gekennzeichnet, dass** das Ätzen durch die harte Maske hindurch mittels eines Plasmas mit einer Gasmischung erfolgt, die erste Anteile enthält, um den ersten Bereich (16) der Flanken (11) des tiefen Isoliergrabens zu realisieren, und zweite Anteile, um den zweiten Bereich (17, 18, 19) der Flanken (11) des tiefen Isoliergrabens zu realisieren.

14. Verfahren zur Herstellung eines Isoliergrabens nach Anspruch 13, **dadurch gekennzeichnet, dass** die Gasmischung Bromwasserstoffsäure HBr, Sauerstoff O₂ und Schwefelhexafluorid SF₆ enthält.

15. Verfahren zur Herstellung eines Isoliergrabens nach einem der Ansprüche 13 oder 14, **dadurch gekennzeichnet, dass** die Gasmischung einen größeren Anteil an Schwefelhexafluorid SF₆ enthält, um den zweiten Bereich (17, 18, 19) der Flanken (11) des tiefen Isoliergrabens zu realisieren, als sie enthält, um den ersten Bereich (16) der Flanken (11) des tiefen Isoliergrabens zu realisieren.

16. Verfahren zur Herstellung eines Isoliergrabens nach einem der Ansprüche 12 bis 15, **dadurch gekennzeichnet, dass** das elektrisch isolierende Material (12), das abgeschieden wird, um die Flanken (11) und den Boden (10) des tiefen Isoliergrabens zu bedecken, dotiert ist, wobei auf den Schritt des Abscheidens ein Schritt des thermischen Temperns folgt, der ein Kriechen des elektrisch isolierenden Materials (12) bewirkt.

17. Verfahren zur Herstellung eines Isoliergrabens nach einem der Ansprüche 12 bis 16, **dadurch gekennzeichnet, dass** es einen Schritt des Schrumpfens an der Oberfläche des elektrisch isolierenden Materials (12) umfasst, das abgeschieden wird, um den Boden (10) und die Flanken (11) des tiefen Isoliergrabens zu bedecken, worauf erforderlichenfalls ein Schritt des Planarmachens folgt.

18. Verfahren zur Herstellung eines Isoliergrabens nach einem der Ansprüche 12 bis 17, **dadurch gekennzeichnet, dass** es nach dem Schritt des Ätzens durch die harte Maske hindurch einen Schritt des thermischen Temperns umfasst, der darauf abzielt, den Oberflächenzustand der Flanken (11) und des Bodens (10) des tiefen Isoliergrabens wiederherzustellen.

19. Verfahren zur Herstellung eines Isoliergrabens nach einem der Ansprüche 12 bis 18, **dadurch gekennzeichnet, dass** es nach dem Schritt des Ätzens durch die harte Maske hindurch einen Schritt der Ionenimplantation im Bereich des tiefen Isoliergrabens umfasst, wobei diese Ionenimplantation zu einem Typ gehört, der jenem des Halbleitersubstrats (1) entgegengesetzt ist.
